# FASCICULE DE BREVET EUROPEEN

(11) **EP 3 172 946 B1**
(45) Date de publication et mention de la délivrance du brevet: **09.12.2020**
(21) Numéro de dépôt: 15759498.7
(22) Date de dépôt: 08.07.2015
(51) Int. Cl.: H05K 1/14, H05K 7/14, F04D 17/10, F04D 29/58, F04D 25/06, H02K 5/22, H02K 11/33, H05K 1/02, H05K 1/05, F02B 39/10

(54) **DISPOSITIF ÉLECTRONIQUE D'UN COMPRESSEUR DE SURALIMENTATION ÉLECTRIQUE**
ELECTRISCHES GERÄT VON EINEM AUFLADEGERÄT KOMPRESSOR
ELECTRONIC DEVICE OF A SUPERCHARGER COMPRESSOR

(30) Priorité: 23.07.2014 FR 1457110
(43) Date de publication de la demande: 31.05.2017
(73) Titulaire: Valeo Equipements Electriques Moteur, 94046 Créteil Cedex (FR)
(72) Inventeur: GUERIN, Fabien, 92320 Chatillon (FR); DUARTE, Johnny, 94046 CRETEIL (FR); CANCIANI, Thierry, 78600 Maisons Laffitte (FR)
(74) Mandataire: Novembre, Christophe Adelphe
(86) Numéro de dépôt international: PCT/FR2015/051892
(87) Numéro de publication internationale: WO 2016/012688

(56) Documents cités:
- EP-A1- 2 355 628
- EP-A1- 2 467 001
- WO-A1-2008/125381
- WO-A1-2010/081123
- WO-A1-2013/161142
- WO-A1-2014/042242
- WO-A1-2014/085487
- WO-A2-2007/033849
- DE-A1-102011 054 818
- FR-A1- 2 856 109
- FR-A1- 2 871 022
- US-A1- 2008 158 824
- US-A1- 2008 186 689
- US-A1- 2009 086 455

## Description

La présente invention concerne un dispositif électronique, notamment d'un compresseur de suralimentation électrique.

Des considérations écologiques, et notamment la lutte contre le réchauffement climatique en réduisant les émissions de CO₂, ont amené les équipementiers à proposer aux constructeurs d'automobiles des compresseurs de suralimentation électriques qui améliorent la réponse dynamique des moteurs à combustion interne de faible cylindrée à bas régime.

A la différence des compresseurs de suralimentation classiques entraînés par les gaz d'échappement, le compresseur de suralimentation électrique, c'est-à-dire entraîné par un moteur électrique, présente un temps de réponse instantané, et améliore le couple moteur à bas régime et l'accélération.

Ce système permet de réduire considérablement la cylindrée des moteurs thermiques, et par conséquent de réduire la consommation de carburant.

Dans le cas d'un moteur diesel, le temps de latence d'un compresseur de suralimentation à gaz est aussi responsable de l'émission de particules quand, dans une phase d'accélération à bas régime, le système d'injection essaie de fournir la puissance demandée en injectant un surplus de carburant.

Pour pallier cet inconvénient, la société VALEO SYSTEMES DE CONTROLE MOTEUR propose dans sa demande de brevet internationale WO 2013/045821 la mise en œuvre d'un compresseur de suralimentation électrique pour assister le turbocompresseur à gaz au moment de l'enfoncement de la pédale d'accélérateur.

Compte tenu des niveaux de puissance requis, les convertisseurs utilisés dans ces applications ne sont plus réalisés sous forme de modules intégrant des composants électroniques sur des circuits imprimés en époxy (de type FR4), mais font appel à la technologie des substrats métalliques isolés (SMI) qui permet une meilleure dissipation thermique des composants de puissance.

Afin de commander électriquement cette carte de puissance, un second circuit permettant de commander électroniquement est utilisé. Cette fonction de commande peut être réalisée grâce à une carte électronique de contrôle, placée au-dessus de la carte de puissance pour faciliter la connexion entre les deux cartes. Les composants de contrôle, à l'opposé des composants de puissance, produisent peu de chaleur, et ne nécessitent donc pas d'être réalisés sur un substrat métallique isolé. De ce fait, la carte de contrôle consiste en composants électroniques sur un circuit imprimé en époxy (de type FR4).

Compte-tenu de la différence de fonction et de comportement entre la carte de puissance et la carte de contrôle, il est préférable que les deux cartes soient distinctes l'une de l'autre. Cependant, l'espace alloué pour le dispositif électronique du compresseur de suralimentation électrique étant limité, les cartes doivent être suffisamment proches pour assurer une bonne connexion entre elles et occuper le moins d'espace possible dans l'ensemble final. L'espace entre les cartes nécessite donc d'être précisément maitrisé, aussi pour éviter le contact entre les composants des deux cartes.

De plus, pour faciliter l'assemblage de l'ensemble du compresseur de suralimentation électrique, il est préférable que les deux cartes soient montées en un seul bloc, et fixées solidement entres elles. De ce fait, le dispositif électronique composé des deux cartes peut être assemblé facilement dans le compresseur de suralimentation électrique, avec la carte de puissance réalisée sur un substrat métallique isolé plaquée sur le fond du boîtier du compresseur, de manière à assurer la dissipation thermique du dispositif électronique.

De l'état de l'art sont connus les documents WO-A2-2007/033849, DE-A1-10 2011 054818, EP-A1-2 467 001, WO-A1-2014/042242, US-A1-2008/158824, US-A1-2009/086455, WO-A1-2013/161142, EP-A1-2 355 628.

La présente invention vise à décrire une pièce intermédiaire permettant de fixer les deux cartes en un ensemble qui sera lui-même fixé sur le fond du boîtier du compresseur de suralimentation électrique.

A cet effet, la présente invention a pour objet un dispositif électronique, tel que défini dans la revendication 1.

Avantageusement, l'utilisation d'une pièce intermédiaire pour maintenir en liaison les cartes électroniques permet de maîtriser la distance entre les deux cartes. En effet, il est préférable de maitriser l'écart entre les deux cartes pour éviter tout contact entre les composants présents sur chaque carte. De plus, cette pièce intermédiaire peut aussi servir de protection contre les projections lors de soudures électriques, soudures nécessaires lors du montage final. En outre, la pièce intermédiaire permet de monter les deux cartes en un seul bloc.

Aussi, les deux cartes devant être connectées électriquement, la connexion pourrait être réalisée au moyen de la pièce intermédiaire. Enfin, la pièce intermédiaire étant fixées aux deux cartes, il est possible de dissiper la chaleur présente dans l'une des cartes vers l'autre carte au moyen de ladite pièce intermédiaire, puis dissiper cette chaleur dans un dissipateur thermique. Par exemple, une carte, dite carte du dessous, est plaquée sur un dissipateur thermique, notamment par l'intermédiaire d'une face de la carte du dessous qui est opposée à l'autre carte, dite carte du dessus. La chaleur présente dans la carte du dessus se dissipe vers la carte du dessous au moyen de ladite pièce intermédiaire, puis la chaleur est dissipée dans le dissipateur thermique par l'intermédiaire de la carte du dessous. Le dissipateur thermique peut être un boîtier d'une machine électrique et/ou d'un compresseur de suralimentation électrique.

Le dispositif électronique selon l'invention peut également comprendre une ou plusieurs des caractéristiques ci-dessous, considérées individuellement ou selon toutes les combinaisons techniquement possibles :
- l'encombrement de la pièce intermédiaire est limité à un espace compris entre les plans dans lesquels s'étendent les cartes électroniques ; et/ou
- une des cartes, dite première carte, est destinée à être plaquée sur un dissipateur thermique par l'intermédiaire d'une des ses faces qui est opposée à l'autre carte, dite seconde carte ; et/ou
- l'une des cartes électroniques, en particulier la première carte, est une carte électronique de puissance comprenant notamment des composants destinés à être parcourus par une énergie électrique alimentant la machine électrique ; et/ou
- l'une des cartes, en particulier la première carte, est réalisée sur un substrat métallique isolé ; et/ou
- l'une des cartes électroniques, en particulier la seconde carte, est une carte électronique de contrôle comprenant notamment des composants destinés à commander l'alimentation électrique de la machine ; et/ou
- l'une des cartes, en particulier la seconde carte, est réalisée sur un circuit imprimé en époxy; et/ou
- la pièce intermédiaire est en matériau isolant électriquement; et/ou
- la pièce intermédiaire est en un matériau qui conserve sa forme à des températures de four de refusions; et/ou
- la pièce intermédiaire a une forme générale de ceinture; et/ou
- la pièce intermédiaire se trouve en périphérie des cartes électroniques, en particulier la pièce intermédiaire recouvre une zone respective de chaque carte, ladite zone partant du bord périphérique de la carte vers l'intérieur de la carte ; cette zone est notamment limitée pour que la pièce périphérique présente une forme générale de ceinture ; et/ou
- la pièce intermédiaire comprend des ouvertures disposées de tel sorte que des composants placés sur les cartes électroniques puissent y prendre place; et/ou
- la pièce intermédiaire comprend au moins une zone d'appui en contact avec au moins l'une des cartes, notamment les ouvertures et les zones d'appui alternent dans la pièce intermédiaire ; et/ou
- les cartes électroniques sont fixées à la pièce intermédiaire par bouterollage; et/ou
- la pièce intermédiaire comporte des pions d'indexation des cartes électroniques; et/ou
- au moins une partie des pions d'indexation est utilisée pour la fixation des cartes électroniques à la pièce intermédiaire par bouterollage; et/ou
- la pièce intermédiaire comprend des inserts métalliques surmoulés aptes à accueillir des organes de fixation, les cartes électroniques comprenant chacune des trous traversants et étant disposées de sorte que lesdits trous traversants soient en regard des inserts métalliques de la pièce intermédiaire, les organes de fixation pouvant être notamment des vis; et/ou
- les inserts métalliques surmoulés se trouvent au niveau de zones d'appui présentes sur la pièce intermédiaire; et/ou
- les organes de fixation comprennent respectivement une tête en appui sur les inserts métalliques surmoulés; en particulier, lorsque les organes de fixation sont des vis, les têtes de vis sont en appui sur les inserts métalliques surmoulés ; et/ou
- en particulier, la seconde carte électronique comprend en son sein des pistes métalliques, notamment en cuivre, en contact avec les inserts métalliques surmoulés; et/ou
- la pièce intermédiaire comprend une pièce de liaison électrique connectée à au moins une carte électronique et destinée à servir de liaison électrique entre ladite au moins une carte électronique et l'extérieur du dispositif, en particulier une électronique d'un véhicule; et/ou
- la pièce de liaison électrique comprend des pions d'indexations de ladite au moins une carte électronique ; et/ou
- la pièce de liaison électrique comprend un premier peigne de connexion destiné à être connecté à l'extérieur du dispositif, en particulier à une électronique d'un véhicule, et un deuxième peigne de connexion connecté à ladite au moins une carte électronique ; et/ou
- la pièce intermédiaire comprend des pièces de maintien permettant de maintenir des éléments de connexion électrique entre une des cartes, en particulier la première carte, et une phase de la machine électrique.

L'invention se rapporte également à un compresseur de suralimentation électrique comprenant un tel dispositif électronique.

L'invention sera mieux comprise à la lumière de la description suivante qui n'est donnée qu'à titre indicatif et qui n'a pas pour but de limiter ladite invention, accompagnée des figures ci-dessous :
- La figure 1 est une vue éclatée d'un compresseur de suralimentation électrique selon un ancien mode de réalisation,
- La figure 2 représente la pièce intermédiaire permettant de fixer les cartes entres elles selon un mode de réalisation de l'invention,
- La figure 3 présente une vue de dessus du dispositif électronique,
- La figure 4 présente une vue de dessous du dispositif électronique,
- La figure 5 représente le dispositif électronique selon un mode de réalisation de l'invention comprenant un insert métallique,
- La figure 6 montre la pièce intermédiaire selon un mode de réalisation de l'invention comprenant une pièce de liaison électrique, et
- La figure 7 montre la pièce intermédiaire et une pièce de maintien selon un mode de réalisation de l'invention.

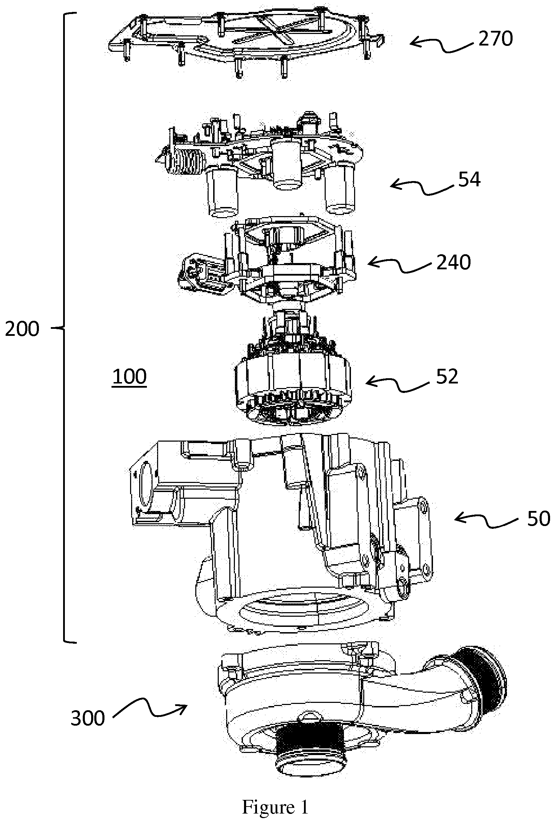

Un exemple de compresseur de suralimentation 100 de véhicule automobile destiné à un système de suralimentation d'un moteur thermique selon un mode de réalisation de l'art antérieur est représenté sur la figure 1.

Comme représenté sur la figure 1, le compresseur de suralimentation 100 comprend une machine électrique tournante 200 et une turbine 300 accouplée à ladite machine électrique tournante 200.

Comme illustré sur la figure 1, la machine électrique tournante 200 comprend un moteur électrique 52 dont les phases sont connectées, par exemple via un dispositif de connexion 240 à une carte électronique de puissance 54. L'ensemble de ces éléments peut être disposé à l'intérieur d'un boîtier 50 fermé par un couvercle 270.

Un exemple de compresseur de suralimentation électrique selon l'invention est similaire à celui illustré en figure 1, si ce n'est qu'il comprend entre autres une carte électronique de contrôle et une pièce intermédiaire fixant les cartes entre elles.

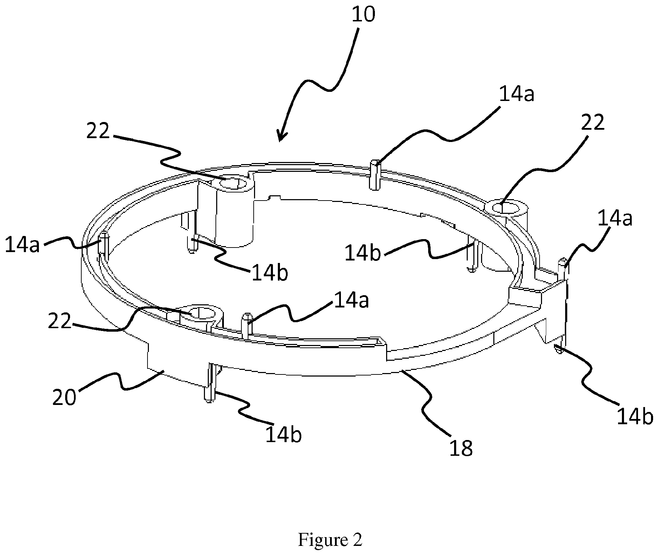

La figure 2 présente une pièce intermédiaire 10 selon un mode de réalisation de l'invention permettant de fixer les cartes de puissance 54 et de contrôle 56 entres elles. Les cartes de puissance 54 et de contrôle 56 sont superposées. La pièce intermédiaire 10 permet de maintenir en place les cartes 54, 56 l'une au dessus de l'autre. La pièce intermédiaire 10 est de forme cylindrique, assimilée à une forme de ceinture ; et peut avoir un diamètre égal ou inférieur à celui des cartes électroniques de puissance 54 ou de contrôle 56. Cela permet à la pièce de se trouver en périphérie des cartes électroniques, permettant ainsi de rendre la pièce intermédiaire 10 moins intrusive par rapport au routage desdites cartes électroniques. La pièce intermédiaire 10 est réalisée en matériau isolant électriquement afin d'éviter tout risque de court-circuit.

En outre, la pièce intermédiaire (10) est réalisée en matériau résistant à des températures élevées, de sorte que ladite pièce intermédiaire (10) puisse conserver sa forme sous l'effet de températures de four de refusion.

Des pions 14a, 14b de matières plastiques sont disposés de part et d'autre de la pièce intermédiaire 10, notamment sur la surface supérieure et inférieure de la pièce intermédiaire 10. Dans ce mode de réalisation, la pièce intermédiaire 10 compte quatre pions 14a sur la surface supérieure et quatre pions 14b sur la surface inférieure, pour assurer un bon maintien des cartes de puissance 54 et de contrôle 56 sur la pièce intermédiaire 10, ainsi que le positionnement relatif desdites cartes sur ladite pièce intermédiaire 10. La pièce intermédiaire 10 comprend des inserts métalliques 22 qui serviront à fixer le dispositif électronique au boîtier 50 du compresseur de suralimentation électrique 100. De plus, la pièce intermédiaire 10 comprend des ouvertures 18 et des zones d'appui 20, les ouvertures 18 étant disposées de tel sorte que des composants placés sur les cartes de puissance 54 et/ou de contrôle 56 puissent y prendre place.

Ces ouvertures 18 permettent le bon emboitement de la pièce intermédiaire 10 avec la carte de puissance 54 sans entrer en contact avec les composants présents sur ladite carte de puissance 54. Entre ces ouvertures 18, des zones d'appui 20 entre la pièce intermédiaire 10 et le substrat métallique isolé 55 sont réparties autour du cylindre. Dans ce mode de réalisation, la pièce intermédiaire 10 comprend trois à quatre zones d'appui 20 pour assurer la stabilité de la structure. La hauteur maximale de la pièce intermédiaire 10 correspond à la hauteur au niveau des zones d'appui 20. Cette hauteur permet de fixer la distance entre la carte de puissance 54 et la carte de contrôle 56 et d'empêcher les composants présents sur l'une ou l'autre d'entrer en contact. Généralement, les inserts métalliques 22 se trouvent au niveau des zones d'appui 20.

De plus, les pions 14a, disposés sur la surface supérieure de la pièce intermédiaire 10, sont destinés à être placés dans des trous correspondants sur le circuit imprimé en époxy 57 pour ensuite assurer la fixation de la carte de contrôle 56 sur la pièce intermédiaire 10. Une fois la carte de contrôle 56 placée, la fixation peut être réalisée par bouterollage des pions 14a. Les pions 14b, disposés sur la surface inférieure de la pièce intermédiaire 10, sont destinés à être placés dans des trous correspondants sur le substrat métallique isolé 55 pour ensuite assurer la fixation de la carte de puissance 54 sur la pièce intermédiaire 10.

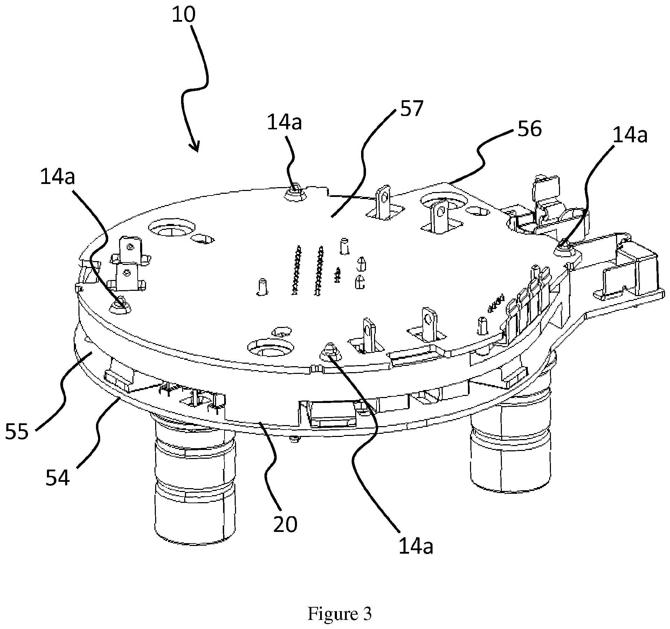

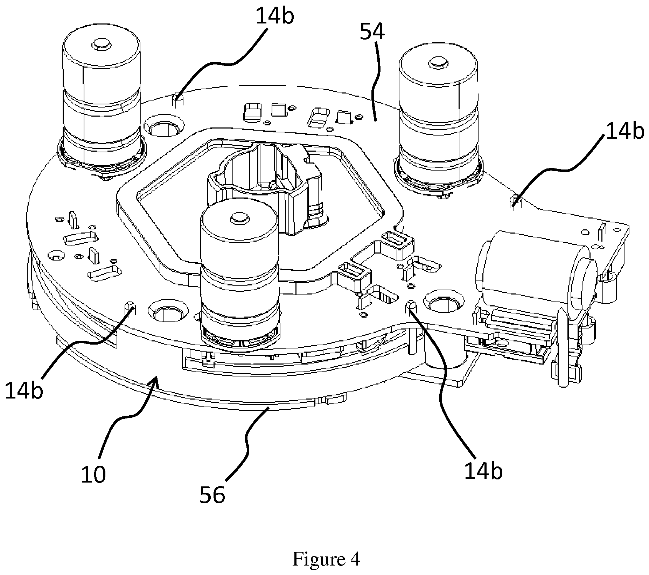

Une fois la carte de puissance 54 placée, la fixation peut être réalisée par bouterollage des pions 14b. La figure 4 permet de voir la face inférieure du dispositif électronique avec les pions 14b dépassant de la surface du substrat métallique isolé 55, donc avant fixation par bouterollage des pions 14b. De même, la figure 3 montre la face supérieure du dispositif électronique avec les pions 14a dépassant de la surface du circuit imprimé en époxy 57, donc avant fixation par bouterollage des pions 14a.

Dans un autre mode de réalisation, cette fixation peut être réalisée par l'intermédiaire de vis de fixation. Cependant, la fixation par bouterollage des pions 14a, 14b reste préférable car la zone d'exclusion est moins importante lors d'un bouterollage de pion d'indexation, en comparaison avec la zone d'exclusion d'un vissage. De plus, la fixation par bouterollage des pions 14a, 14b placés directement sur la pièce intermédiaire 10 permet de contenir les contraintes mécaniques à la pièce intermédiaire, limitant ainsi les contraintes sur les cartes électroniques et le risque d'endommager les contacts électriques.

De plus, dans un mode de réalisation de l'invention, la pièce intermédiaire 10 comprend trois inserts métalliques surmoulés 22, permettant de fixer le dispositif électronique sur le fond du boîtier 50 du compresseur de suralimentation électrique 100. Ces inserts métalliques 22 étant fixés à la pièce intermédiaire 10, et les cartes de puissance 54 et de contrôle 56 étant elles-mêmes fixées à la pièce intermédiaire 10, la fixation du dispositif électronique se fait en vissant au niveau des inserts métalliques 22 au fond du boîtier 50 du compresseur de suralimentation électrique 100 à l'aide de vis 26. Les inserts 22 permettent de supporter les efforts mis enjeu par les vis 26 lors de la fixation sur le fond du boîtier 50.

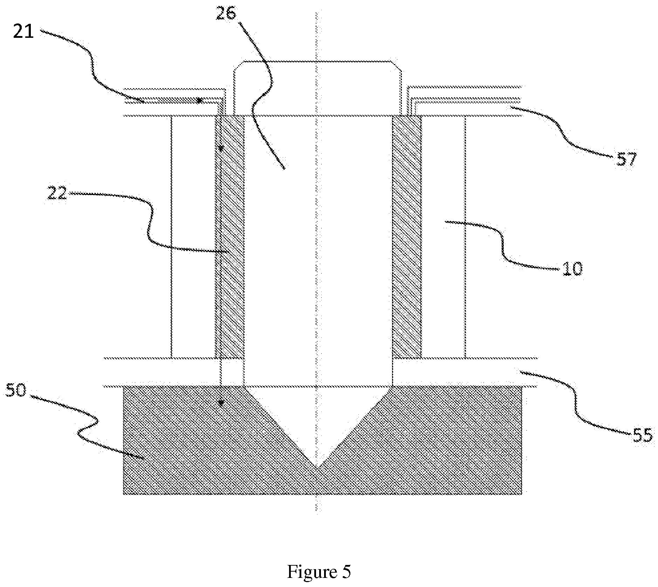

La figure 5 illustre l'interaction entre l'insert 22 et le circuit imprimé en époxy 57 ainsi que le substrat métallique isolé 55. L'insert est en contact avec le substrat métallique isolé 55, ce qui permet, lors de la fixation du dispositif électronique sur le boîtier 50, de plaquer le substrat métallique isolé 55 sur le fond dudit boîtier 50, et ainsi d'assurer un bon transfert thermique entre le substrat métallique isolé 55 et le fond du boîtier 50.

Selon une variante non représentée de l'invention, l'insert 22 peut être directement en contact avec le fond du boîtier 50. Dans cette variante, l'insert 22 est sur la périphérie de la pièce intermédiaire 10. La hauteur de l'insert 22 correspond aux hauteurs cumulées de l'espace entre les deux cartes 54, 56 et de la carte de puissance 54. Ainsi, lorsqu'un organe de fixation, tel la vis 26, est introduite dans l'insert 22 et dans le fond du boîtier 50, le substrat métallique isolé 55 est plaqué sur le fond du boîtier 50.

De plus, des pistes de cuivres 21 présentes dans le circuit imprimé en époxy 57 permettent de faire la liaison entre des points chauds dans la carte de contrôle 56 et l'insert métallique 22. De ce fait, la chaleur présente dans le circuit imprimé en époxy 57 diffuse jusqu'au fond du boîtier 50 par l'intermédiaire de l'insert métallique 22, en suivant les flèches figurant sur la figure 5. Les inserts métalliques 22 servent ainsi de diffuseurs thermiques.

La vis 26 permet de fixer l'ensemble sur le fond du boîtier 50. La tête de la vis 26 est, dans l'exemple présenté en figure 5, en appui sur l'insert métallique surmoulé 22 et non sur la carte de contrôle 56. Cela permet de limiter les contraintes de vissage sur la carte de contrôle 56, et ainsi dispense la carte de contrôle 56 de nécessité d'une distance de sécurité autour du trou correspondant au vissage.

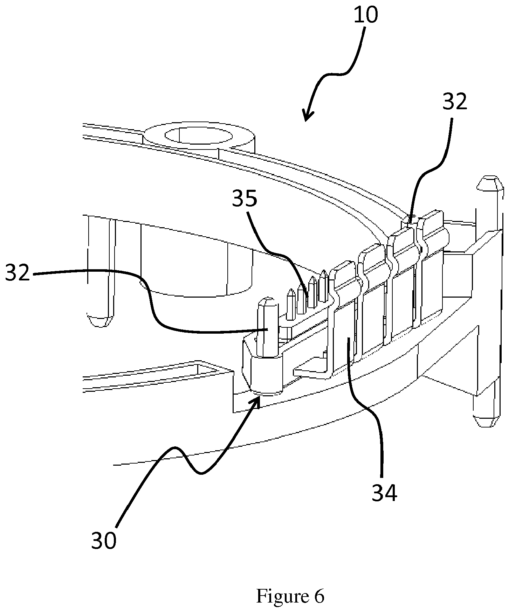

Dans un mode de réalisation de l'invention, la pièce intermédiaire 10 peut comprendre une pièce d'interface 30 en plastique permettant de faire l'interface entre la carte de contrôle 56 et une embase connecteur client, comme le montre la figure 6. Cette pièce d'interface 30 peut être directement surmoulée sur ladite pièce intermédiaire 10. Cette pièce d'interface 30 comprend des pions d'indexation 32 qui viendront se loger dans un trou correspondant dans le circuit imprimé en époxy 57, ainsi qu'un peigne de connexion 34 directement surmoulé sur la pièce d'interface 30 et permettant la connexion électrique avec par exemple une électronique d'un véhicule dans lequel est embarqué le compresseur de suralimentation électrique. La pièce intermédiaire 30 dispose aussi d'un peigne de connexion 35 directement surmoulé sur ladite pièce intermédiaire permettant la connexion électronique avec la carte de contrôle 56.

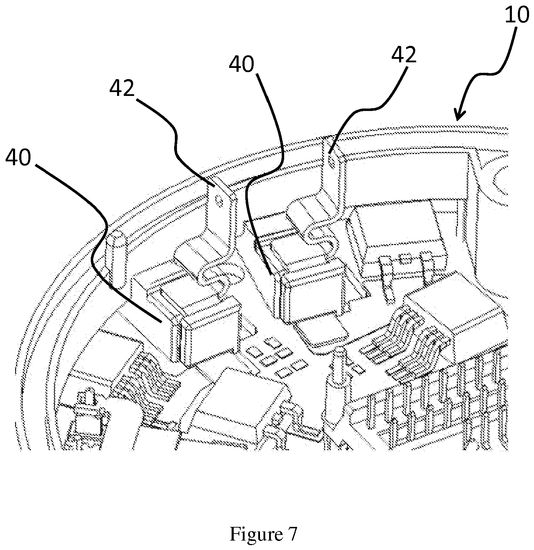

De plus, les phases de la machine électrique 52 doivent être reliées au substrat métallique isolé 55, généralement par l'intermédiaire de jeux de barre 42 connectés à la carte électronique de puissance 54. Dans un mode de réalisation de l'invention présenté en figure 7, les jeux de barre 42 sont maintenus par des pièces de maintien 40 en plastique directement intégrées à la pièce intermédiaire 10. Les pièces de maintien 40 étant en contact direct avec des jeux de barre 42, il est préférable que le plastique utilisé pour fabriquer lesdites pièces de maintien 40 résiste à des températures de four de refusion.

Par la suite, des jeux de barres provenant des phases de la machine 52 viennent en vis-à-vis des jeux de barre 42 de la carte électronique de puissance 54 afin de réaliser la connexion entre ladite carte électronique de puissance 54 et les phases. Une connexion électrique entre les jeux de barre 42 et les jeux de barre issus des phases est réalisée, par soudage par exemple.

L'invention n'est pas limitée aux modes de réalisation particuliers qui ont été décrits ci-dessus, de nombreuses variantes pouvant être conçues sans sortir de la portée définie par les revendications jointes. En particulier, selon un mode de réalisation, le fond du boîtier 50 fait parti d'un dissipateur thermique sur lequel la première carte 54 est plaquée. Notamment, ce dissipateur thermique fait parti d'un circuit de refroidissement du compresseur de suralimentation.

## Revendications

1. Dispositif électronique, notamment destiné à l'alimentation d'une machine électrique (52), comprenant deux cartes électroniques (54, 56) superposées et une pièce intermédiaire rigide (10) disposée entre lesdites deux cartes électroniques (54, 56) de sorte que lesdites cartes soient fixées l'une à l'autre par ladite pièce intermédiaire (10), la pièce intermédiaire (10) comprend en outre des inserts métalliques surmoulés (22) aptes à accueillir des organes de fixation (26),
les cartes électroniques (54, 56) comprennent chacune des trous traversants et sont disposées de sorte que lesdits trous traversants soient en regard des inserts métalliques (22) de la pièce intermédiaire (10),
une des cartes, dite première carte (54), est destinée à être plaquée sur un dissipateur thermique par l'intermédiaire d'une des ses faces qui est opposée à l'autre carte, dite seconde carte (56), et ladite seconde carte (56) comprend en son sein des pistes métalliques (21) en contact avec les inserts métalliques surmoulés (22).

2. Dispositif électronique selon la revendication précédente, dans lequel la pièce intermédiaire (10) à une forme générale de ceinture.

3. Dispositif électronique selon l'une des revendications précédentes, dans lequel la pièce intermédiaire (10) se trouve en périphérie des cartes électroniques (54, 56).

4. Dispositif électronique selon l'une des revendications précédentes, dans lequel la pièce intermédiaire (10) comprend des ouvertures (18) disposées de tel sorte que des composants placés sur les cartes électroniques (54, 56) puissent y prendre place.

5. Dispositif électronique selon l'une des revendications précédentes, dans lequel la pièce intermédiaire (10) comprend au moins une zone d'appui (20) en contact avec au moins l'une des cartes (54, 56).

6. Dispositif électronique selon l'une des revendications précédentes, dans lequel les cartes électroniques (54, 56) sont fixées à la pièce intermédiaire (10) par bouterollage.

7. Dispositif électronique selon l'une des revendications précédentes, dans lequel la pièce intermédiaire (10) comporte des pions d'indexation (14a, 14b) des cartes électroniques (54, 56).

8. Dispositif électronique selon les revendications 6 et 7, dans lequel au moins une partie des pions d'indexation (14a, 14b) est utilisée pour la fixation des cartes électroniques (54, 56) à la pièce intermédiaire (10) par bouterollage.

9. Dispositif électronique selon l'une des revendications précédentes et la revendication 5, dans lequel les inserts métalliques surmoulés (22) se trouvent au niveau de zones d'appui (20) présentes sur la pièce intermédiaire (10).

10. Dispositif électronique selon l'une des revendications précédentes, dans lequel les organes de fixation (26) comprennent respectivement une tête en appui sur les inserts métalliques surmoulés (22).

11. Dispositif électronique selon l'une des revendications précédentes, dans lequel la pièce intermédiaire (10) comprend une pièce de liaison électrique (30) connectée à au moins une des cartes électroniques (54, 56) et destinée à servir de liaison électrique entre ladite au moins une carte électronique et l'extérieur du dispositif.

12. Dispositif électronique selon la revendication 11, dans lequel la pièce de liaison électrique (30) comprend des pions d'indexations (32) de ladite au moins une carte électronique.

13. Dispositif électronique selon les revendications 11 ou 12, dans lequel la pièce de liaison électrique (30) comprend un premier peigne de connexion (34) destiné à être connecté à l'extérieur du dispositif et un deuxième peigne de connexion (35) connecté à ladite au moins une carte électronique.

14. Dispositif électronique selon l'une des revendications précédentes, dans lequel la pièce intermédiaire (10) comprend des pièces de maintien (40) permettant de maintenir des éléments de connexion électrique (42) entre une des cartes (54) et une phase de la machine électrique (52).

15. Un compresseur de suralimentation électrique (100) comprenant un dispositif électronique selon l'une des revendications précédentes.

## Patentansprüche

1. Elektronische Vorrichtung, welche insbesondere zur Versorgung einer elektrischen Maschine (52) bestimmt ist und zwei übereinanderliegende Leiterplatten (54, 56) und ein starres Zwischenteil (10), das zwischen den zwei Leiterplatten (54, 56) so angeordnet ist, dass die Leiterplatten durch das Zwischenteil (10) aneinander befestigt sind, umfasst, wobei das Zwischenteil (10) außerdem umspritzte metallische Einsätze (22) umfasst, die geeignet sind, Befestigungsorgane (26) aufzunehmen, wobei die Leiterplatten (54, 56) jeweils Durchgangslöcher umfassen und so angeordnet sind, dass sich die Durchgangslöcher gegenüber den metallischen Einsätzen (22) des Zwischenteils (10) befinden,
**dadurch gekennzeichnet, dass** eine der Leiterplatten, erste Leiterplatte (54) genannt, dazu bestimmt ist, mit einer ihrer Seiten, welche der anderen Leiterplatte, zweite Leiterplatte (56) genannt, gegenüberliegt, an einen Kühlkörper angedrückt zu werden, und die zweite Leiterplatte (56) in ihrem Inneren Metallbahnen (21) umfasst, die sich mit den umspritzten metallischen Einsätzen (22) in Kontakt befinden.

2. Elektronische Vorrichtung nach dem vorhergehenden Anspruch, wobei das Zwischenteil (10) die allgemeine Form eines Gürtels hat.

3. Elektronische Vorrichtung nach einem der vorhergehenden Ansprüche, wobei sich das Zwischenteil (10) am Umfang der Leiterplatten (54, 56) befindet.

4. Elektronische Vorrichtung nach einem der vorhergehenden Ansprüche, wobei das Zwischenteil (10) Öffnungen (18) umfasst, die derart angeordnet sind, dass auf den Leiterplatten (54, 56) angeordnete Komponenten dort Platz finden können.

5. Elektronische Vorrichtung nach einem der vorhergehenden Ansprüche, wobei das Zwischenteil (10) wenigstens einen Anlagebereich (20) umfasst, der sich mit wenigstens einer der Leiterplatten (54, 56) in Kontakt befindet.

6. Elektronische Vorrichtung nach einem der vorhergehenden Ansprüche, wobei die Leiterplatten (54, 56) an dem Zwischenteil (10) mittels des Bouterollage-Verfahrens befestigt sind.

7. Elektronische Vorrichtung nach einem der vorhergehenden Ansprüche, wobei das Zwischenteil (10) Stifte zur Positionierung (14a, 14b) der Leiterplatten (54, 56) aufweist.

8. Elektronische Vorrichtung nach den Ansprüchen 6 und 7, wobei wenigstens ein Teil der Positionierungsstifte (14a, 14b) zur Befestigung der Leiterplatten (54, 56) an dem Zwischenteil (10) mittels des Bouterollage-Verfahrens verwendet wird.

9. Elektronische Vorrichtung nach einem der vorhergehenden Ansprüche und Anspruch 5, wobei sich die umspritzten metallischen Einsätze (22) an am Zwischenteil (10) vorhandenen Anlagebereichen (20) befinden.

10. Elektronische Vorrichtung nach einem der vorhergehenden Ansprüche, wobei die Befestigungsorgane (26) jeweils einen Kopf umfassen, der an den umspritzten metallischen Einsätzen (22) anliegt.

11. Elektronische Vorrichtung nach einem der vorhergehenden Ansprüche, wobei das Zwischenteil (10) ein elektrisches Verbindungsteil (30) umfasst, das mit wenigstens einer der Leiterplatten (54, 56) verbunden ist und dazu bestimmt ist, als elektrische Verbindung zwischen der wenigstens einen Leiterplatte und der Außenseite der Vorrichtung zu dienen.

12. Elektronische Vorrichtung nach Anspruch 11, wobei das elektrische Verbindungsteil (30) Stifte zur Positionierung (32) der wenigstens einen Leiterplatte umfasst.

13. Elektronische Vorrichtung nach den Ansprüchen 11 oder 12, wobei das elektrische Verbindungsteil (30) einen ersten Verbindungskamm (34), der dazu bestimmt ist, mit der Außenseite der Vorrichtung verbunden zu werden, und einen zweiten Verbindungskamm (35), der mit der wenigstens einen Leiterplatte verbunden ist, umfasst.

14. Elektronische Vorrichtung nach einem der vorhergehenden Ansprüche, wobei das Zwischenteil (10) Halteteile (40) umfasst, die es ermöglichen, Elemente zur elektrischen Verbindung (42) zwischen einer der Leiterplatten (54) und einer Phase der elektrischen Maschine (52) zu halten.

15. Elektrischer Ladekompressor (100), welcher eine elektronische Vorrichtung nach einem der vorhergehenden Ansprüche umfasst.

## Claims

1. Electronic device, intended in particular to supply power to an electrical machine (52), comprising two superimposed electronic boards (54, 56) and a rigid intermediate component (10) positioned between said two electronic boards (54, 56) such that said boards are fastened to one another by said intermediate component (10), the intermediate component (10) furthermore comprises overmoulded metal inserts (22) able to receive fastening members (26),
the electronic boards (54, 56) each comprise through-apertures and are positioned such that said through-apertures face metal inserts (22) of the intermediate component (10), **characterized in that**
one of the boards, called first board (54), is intended to be pressed against a heat sink by way of one of its faces that is opposite the other board, called second board (56), and said second board (56), at the centre thereof, comprises metal tracks (21) in contact with the overmoulded metal inserts (22).

2. Electronic device according to the preceding claim, wherein the intermediate component (10) is in the general shape of a belt.

3. Electronic device according to either of the preceding claims, wherein the intermediate component (10) is located at the periphery of the electronic boards (54, 56) .

4. Electronic device according to one of the preceding claims, wherein the intermediate component (10) comprises openings (18) that are positioned such that components placed on the electronic boards (54, 56) are able to adopt their positions there.

5. Electronic device according to one of the preceding claims, wherein the intermediate component (10) comprises at least one bearing zone (20) in contact with at least one of the boards (54, 56).

6. Electronic device according to one of the preceding claims, wherein the electronic boards (54, 56) are stake-fastened to the intermediate component (10).

7. Electronic device according to one of the preceding claims, wherein the intermediate component (10) has indexing pieces (14a, 14b) for indexing the electronic boards (54, 56).

8. Electronic device according to Claims 6 and 7, wherein at least some of the indexing pieces (14a, 14b) are used to stake-fasten the electronic boards (54, 56) to the intermediate component (10).

9. Electronic device according to one of the preceding claims and Claim 5, wherein the overmoulded metal inserts (22) are located at the bearing zones (20) that are present on the intermediate component (10).

10. Electronic device according to one of the preceding claims, wherein the fastening members (26) respectively comprise a head bearing on the overmoulded metal inserts (22) .

11. Electronic device according to one of the preceding claims, wherein the intermediate component (10) comprises an electrical connection component (30) connected to at least one of the electronic boards (54, 56) and intended to serve as an electrical connection between said at least one electronic board and the outside of the device.

12. Electronic device according to Claim 11, wherein the electrical connection component (30) comprises indexing pieces (32) for indexing said at least one electronic board.

13. Electronic device according to Claim 11 or 12, wherein the electrical connection component (30) comprises a first connection comb (34) intended to be connected to the outside of the device and a second connection comb (35) connected to said at least one electronic board.

14. Electronic device according to one of the preceding claims, wherein the intermediate component (10) comprises holding components (40) for holding the electrical connection elements (42) between one of the boards (54) and a phase of the electrical machine (52).

15. Electrical supercharger (100) comprising an electronic device according to one of the preceding claims.
